# EUROPEAN PATENT SPECIFICATION

(11) **EP 4 582 888 B1**
(45) Date of publication and mention of the grant of the patent: **30.09.2026**
(21) Application number: 23860856.6
(22) Date of filing: 30.08.2023
(51) Int. Cl.: G05B 13/04, G05B 17/02

(54) **SYSTEM FOR TEST RUN OF FACILITY, METHOD THEREFOR, AND CONTROL DEVICE THEREFOR, USING DIGITAL TWIN**
SYSTEM FÜR EINEN TESTLAUF EINER ANLAGE, VERFAHREN DAFÜR UND STEUERUNGSVORRICHTUNG DAFÜR MIT DIGITALEM ZWILLING
SYSTÈME D'ESSAI DE FONCTIONNEMENT D'INSTALLATION, PROCÉDÉ ASSOCIÉ ET DISPOSITIF DE COMMANDE ASSOCIÉ, FAISANT APPEL À UN JUMEAU NUMÉRIQUE

(30) Priority: 31.08.2022 KR 20220109734; 22.06.2023 KR 20230080115
(43) Date of publication of application: 09.07.2025
(73) Proprietor: LG Energy Solution, Ltd., Seoul 07335 (KR)
(72) Inventor: LEE, Junho, Daejeon 34122 (KR); KIM, Dohyun, Daejeon 34122 (KR)
(74) Representative: Goddar, Heinz J.
(86) International application number: PCT/KR2023/012837
(87) International publication number: WO 2024/049180

(56) References cited:
- CN-A- 112 800 606
- CN-A- 114 924 530
- KR-A- 20060 113 017
- KR-A- 20190 123 895
- KR-A- 20200 081 066
- KR-A- 20220 014 022
- US-A1- 2020 218 243
- AYERBE ELIXABETE ET AL: "Digitalization of Battery Manufacturing: Current Status, Challenges, and Opportunities", ADVANCED ENERGY MATERIALS, vol. 12, no. 17, 9 December 2021 (2021-12-09), Weinheim, XP093325827, ISSN: 1614-6832, DOI: 10.1002/aenm.202102696

## Description

### [Technical Field]

This application claims priority to and the benefit of Korean Patent Application No.10-2022-0109734 filed in the Korean Intellectual Property Office on August 31, 2022 and Korean Patent Application No.10-2023-0080115 filed in the Korean Intellectual Property Office on June 22, 2023.

The present invention relates to a system and method for test running of facilities, and an apparatus for controlling test running of facilities, and more particularly, to a system and method for test running of equipment in facilities, and an apparatus for controlling test running of equipment using a digital twin object.

### [Background Art]

Secondary batteries, capable of recharging and reuse, are used as energy sources for small devices such as smart phones, tablet PCs, and vacuum cleaners, as well as a medium-to-large energy sources for personal mobility, automobiles, and energy storage systems (ESS) for smart grids. Secondary batteries may be used in the form of an assembly such as a battery module in which multiple battery cells are connected in series or parallel, or a battery pack in which battery modules are connected in series or parallel, depending on the requirements of the system.

Batteries can be broadly categorized into cylindrical, pouch, and prismatic types based on their shapes. While these batteries share a common manufacturing process involved with combining of the separator and electrolyte after producing the positive and negative electrodes, they can differ in shape based on their assembly and packaging.

Cylindrical batteries, as the oldest technology with a significant advantage in terms of price competitiveness, are manufactured by rolling and winding the anode and cathode and may have various specifications determined by diameter and height. Notably, with recent applications of cylindrical batteries in electric vehicles, there is a trend toward upsizing their specifications. This increase in battery specification can lead to higher energy density and output, enhanced safety against thermal runaway, and improved cooling efficiency.

Meanwhile, in order to manufacture batteries with different specifications compared to existing ones, new facilities must be manufactured in place of existing facilities and applied to each process. For this reason, it is common to conduct preliminary inspections by test-running new facilities before mass producing products, and accordingly, it is necessary to consider efficient test-run methods that can be expected to reduce labor costs and man-hours required for test-running.

AYERBE ELIXABETE ET AL, "Digitalization of Battery Manufacturing: Current Status, Challenges, and Opportunities", ADVANCED ENERGY MATERIALS, Weinheim, (20211209), vol. 12, no. 17, doi:10.1002/aenm.202102696, ISSN 1614-6832, discloses digital twins for electrode manufacturing processes. Among the examples disclosed is an electrode stochastic generator able to predict how manufacturing parameters impact the electrode mesostructured in 3D. The generator produces a number of electrode mesostructures that can be characterized in terms of surface area of contact, tortuosity of porous media, conductivity, and others.

CN 112800606 A discloses a digital twin production line construction method and system, electronic equipment and a storage medium. The method comprises the following steps: establishing a VR digital twin production line model corresponding to a physical production line; acquiring actual operation data of the physical production line; analyzing the actual operation data of the physical production line to obtain a corresponding actual operation data analysis result; configuring a corresponding relation between the actual operation data and the VR digital twin production line model; and according to the corresponding relationship, transmitting the actual operation data analysis result to the VR digital twin production line model, so that the VR digital twin production line model operates according to the actual operation data analysis result. According to the method, the digital twin production line model can be driven to operate by using real production data, systematic analysis on the production process is facilitated, the production process flow and production resource configuration are optimized, and a basis is provided for accurate production decision making.

CN 114924530 A discloses a remote workpiece polishing debugging operation and maintenance system and method based on a digital twinborn technology. The system comprises a field operation subsystem and a digital twinborn model corresponding to the field operation subsystem. The field operation subsystem comprises an intelligent sensing unit, a visual detection unit, an intelligent control decision unit, a workpiece conveying unit and a grinding execution unit; the digital twin model remotely controls the workpiece conveying unit and the polishing execution unit according to information sent by the intelligent sensing unit and the visual detection unit; the intelligent control decision-making unit is used for processing the received information about whether the workpiece is prepared in place or not and the photographing information, and controlling the workpiece conveying unit to convey the workpiece to be polished to a polishing area; and the workpiece conveying unit transmits the polishing execution information to the polishing execution unit, so that the polishing execution unit begins to polish the workpiece. According to the disclosure, manpower and material resources can be saved, and debugging, operation and maintenance efficiency is improved.

KR 20200081066 A discloses a technology for a digital twin system for automatically generating an optimal control scenario of mechanical equipment using a virtual model simulating actual mechanical equipment and to a method thereof. The digital twin system comprises: an IoT device which receives operation information of the mechanical equipment and controls the operation of the mechanical equipment in response to a control scenario; and a digital twin device including a virtual model simulating the mechanical equipment, correcting the control scenario using the virtual model, and transmitting the corrected control scenario to the IoT device.

KR 20060113017 A discloses a secondary battery which does not uses a PP case and a projection formed at a can and is improved in battery capacity, and a method for preparing a secondary battery. The secondary batterycomprises a jelly-roll type electrode plate assembly which comprises a first electrode plate, a separator and a second electrode plate; a canwhich has an aperture at one side for accommodating the electrode plate assembly, and has at least one beading partformed between the outer circumference of the electrode plate assembly and the aperture for preventing the flowing of the electrode plate assembly after accommodation; and a cap platewhich is received in and fixed to the beading part of the can.

### [Detailed Description of the Invention]

### [Technical Problem]

To obviate one or more problems of the related art, embodiments of the present disclosure provide a system for test running of equipment using digital twin object.

To obviate one or more problems of the related art, embodiments of the present disclosure also provide a method for test running of equipment using digital twin object.

To obviate one or more problems of the related art, embodiments of the present disclosure also provide a control apparatus for test running of equipment using digital twin object.

### [Technical Solution]

The invention is set out in the appended claims. In order to achieve the objective of the present disclosure, a system for test running of equipment using a digital twin object is presented and the digital twin object may include: a virtual model operating unit configured to operate at least one equipment in a virtual world according to at least one control value; a virtual model control unit configured to set at least one control value for operation of at least one equipment in the virtual world and transmit the at least one control value to the virtual model operation unit and receive at least one feedback on the at least one control value from the virtual model operation unit; and an automatic correction logic calculation unit configured to calculate at least one correction value for a virtual model control program based on the at least one feedback on the at least one control value and transmit the at least one correction value to the virtual model control unit.

The system for test running of equipment may include an equipment operation device which includes an equipment driving unit corresponding to the virtual model operating unit, an equipment control unit corresponding to the virtual model control unit, and an automatic correction logic calculation unit corresponding to the automatic correction logic calculation unit of the digital twin object.

The control program which may be determined by the virtual model control unit may be transmitted to the equipment control unit within the equipment operation device.

The automatic correction software which is determined by the automatic correction logic calculation unit may be transmitted to the automatic correction logic calculation unit in the equipment operation device.

The automatic correction logic calculation unit may calculate the automatic correction logic by additionally considering product quality influencing factors along with the at least one feedback on the at least one control value.

The automatic correction logic calculation unit in the equipment operation device may calculate automatic correction logic for the control program based on automatic correction software downloaded from the digital twin object and in consideration of at least one detected product quality related value.

Here, the at least one equipment in the virtual world may include one or more equipment used in one or more of a plurality of processes involved in battery manufacturing.

The at least one control value for the operation of the at least one equipment in the virtual world may include one or more control values associated with one or more of a beading process, a electrolyte injection process, a roll press process, and a notching process.

The at least one control value for the operation of the at least one equipment in the virtual world may include one or more control values of the upper servo movement distance, lower servo movement distance, cell rotation speed, and knife servo movement distance in the beading process.

The at least one control value for the operation of the at least one equipment in the virtual world may include an amount of electrolyte injection in the electrolyte injection process.

According to another embodiment of the present disclosure, a method for test running of equipment using a digital twin object, including a virtual model operation unit, a virtual model control unit, and an automatic correction logic calculation unit, may comprise determining, by the virtual model control unit, at least one control value for operation of at least one equipment in the virtual world and transmitting the at least one control value to the virtual model operation unit; operating, by the virtual model operation unit, at least one equipment model in the virtual world according to the at least one control value received from the virtual model control unit; transmitting, by the virtual model operation unit, at least one feedback on the at least one control value to the virtual model control unit; calculating, by the automatic correction logic calculation unit, at least one correction value for a virtual model control program based on the at least one feedback on the at least one control value; and transmitting, by the automatic correction logic calculation unit, the at least one correction value for the virtual model control program to the virtual model control unit.

The method may further include transmitting the control program which is determined by the virtual model control unit to an equipment control unit within the equipment operation device.

The method may further include transmitting the automatic correction software determined by the automatic correction logic calculation unit to an automatic correction logic calculation unit in the equipment operation device.

The at least one control value for the operation of at least one equipment in the virtual world may include one or more command values related to a position and a speed of each equipment.

The at least one equipment in the virtual world may include one or more equipment used in one or more of a plurality of processes involved in battery manufacturing.

The at least one control value for the operation of the at least one equipment in the virtual world may include one or more control values associated with one or more of a beading process, a electrolyte injection process, a roll press process, and a notching process.

The at least one control value for the operation of the at least one equipment in the virtual world may include one or more control values of the upper servo movement distance, lower servo movement distance, cell rotation speed, and knife servo movement distance in the beading process.

The at least one control value for the operation of the at least one equipment in the virtual world may include an amount of electrolyte injection in the electrolyte injection process.

According to another embodiment of the present disclosure, a control apparatus for equipment test running using a digital twin object according to embodiments of the present invention may include at least one processor and a memory that stores at least one instruction executed by the at least one processor, wherein the at least one instruction may include an instruction to create a digital twin object including a virtual model operation unit, a virtual model control unit, and an automatic correction logic calculation unit; an instruction for the virtual model operation unit to operate at least one equipment model in the virtual world according to at least one control value; an instruction for the virtual model control unit to set at least one control value for operation of at least one equipment in the virtual world and transmit the at least one control value to the virtual model operation unit; an instruction for the virtual model control unit to receive at least one feedback on the at least one control value from the virtual model operation unit; an instruction for the automatic correction logic calculation unit to calculate at least one correction value for a virtual model control program based on the at least one feedback on the at least one control value; and an instruction for the automatic correction logic calculation unit to transmit the at least one correction value for the virtual model control program to the virtual model control unit.

The at least one instruction may further include an instruction to transmit the control program which is determined by the virtual model control unit to an equipment control unit within the equipment operation device.

The at least one instruction may further include an instruction to transmit the automatic correction software determined by the automatic correction logic calculation unit to an automatic correction logic calculation unit in the equipment operation device.

The at least one control value for the operation of at least one equipment in the virtual world may include one or more command values related to a position and a speed of each equipment.

The instruction for the automatic correction logic calculation unit to calculate at least one correction value for a virtual model control program may include an instruction to calculate the automatic correction logic by additionally considering product quality influencing factors along with the at least one feedback on the at least one control value.

The at least one equipment in the virtual world may include one or more equipment used in one or more of a plurality of processes involved in battery manufacturing.

The at least one control value for the operation of the at least one equipment in the virtual world may include one or more control values associated with one or more of a beading process, a electrolyte injection process, a roll press process, and a notching process.

The at least one control value for the operation of the at least one equipment in the virtual world may include one or more control values of the upper servo movement distance, lower servo movement distance, cell rotation speed, and knife servo movement distance in the beading process.

The at least one control value for the operation of the at least one equipment in the virtual world may include an amount of electrolyte injection in the electrolyte injection process.

### [Advantageous Effects]

According to embodiments of the present disclosure, the present invention may efficiently manufacture new facilities through prior verification by facility test run using digital twin technology and apply the manufactured new facilities to mass production.

### [Brief Description of the Drawings]

FIG. 1 is a block diagram of a general equipment test running system using a digital twin.
FIG. 2 is a block diagram of a system for test running of equipment using a digital twin according to embodiments of the present invention.
FIG. 3 is a diagram for explaining automatic correction logic in the system for test running of equipment using a digital twin according to embodiments of the present invention.
FIG. 4 is an operational flowchart of a method for test running of equipment according to embodiments of the present invention.
FIG. 5 is a block diagram of a control apparatus for equipment test running according to embodiments of the present invention.
FIG. 6a is a diagram illustrating a beading process during battery manufacturing process, and FIG. 6b illustrates an example of an automatic correction control factor when applying the automatic correction logic to the beading process according to embodiments of the present invention.
FIG. 7 shows an example of an automatic correction control factor when applying the automatic correction logic to a electrolyte injection process according to embodiments of the present invention.
   - 100:: digital twin object
   - 110:: virtual model operating unit
   - 120:: virtual model control unit
   - 130:: automatic correction logic calculation unit
   - 200:: equipment operation device
   - 210:: equipment driving unit
   - 220:: equipment control unit
   - 230:: automatic correction logic calculation unit

### [Best Modes for Practicing the Disclosure]

The present invention may be modified in various forms and have various embodiments within the scope of the appended claims, which define the invention. Specific embodiments thereof are shown by way of example in the drawings and will be described in detail below. Like reference numerals refer to like elements throughout the description of the figures. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

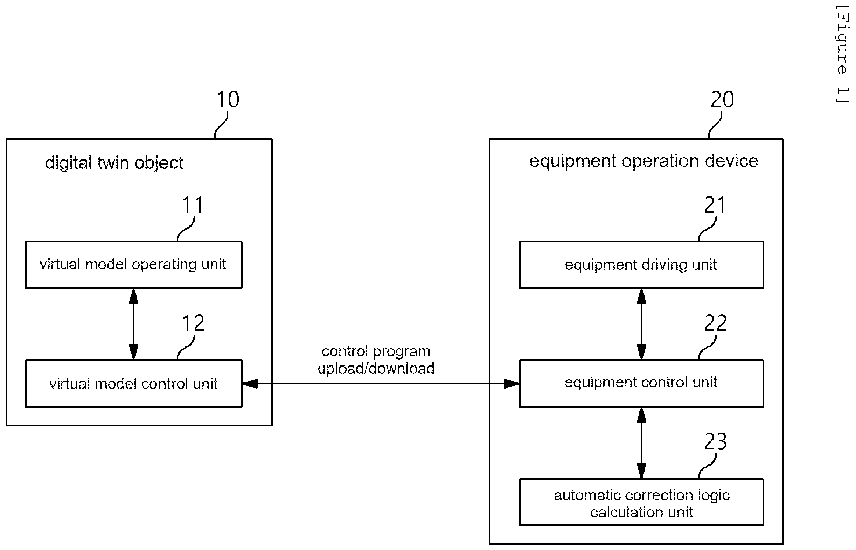

FIG. 1 is a block diagram of a general equipment test running system using a digital twin.

As shown in FIG. 1, the general equipment test running system may include an equipment operation device 20 and a digital twin object 10.

The equipment operation device 20 is a device for manufacturing products by operating various machineries, parts, and device sensors within a manufacturing facility, and may be configured to include an equipment driving unit 21, an equipment control unit 22, and an automatic correction logic calculation unit 23. The equipment driving unit 21 is connected to various devices in the manufacturing facility and operates devices, parts, and sensors which are interconnected with the equipment driving unit 21 according to commands from the equipment control unit 22. The automatic correction logic calculation unit 23 calculates correction values according to a orrection logic based on values detected in relation to quality of a manufactured product according to the operation of the equipment and transmits the correction values to the control program of the equipment control unit 22.

Digital twin refers to a digital asset which is created corresponding to a physical asset and a digital twin object 10 refers to a digital virtual object implemented in a digital environment by replicating the same environment as the actual manufacturing facility with software. A digital twin object may be a solution that is linked to manufacturing equipments to collect data generated from various devices, parts, devices, or sensors in real time and provide it to the operator.

The digital twin object 10 may be configured to include a virtual model operation unit 11 and a virtual model control unit 12. The virtual model control unit 12 receives a user's command and transmits it to the virtual model operation unit 11, and the virtual model operation unit 11 operates the virtual model related to various devices, components, and sensors in the virtual world according to the command. The virtual model operation unit 11 transmits information about the current operating state of a virtual model for an equipment to the virtual model control unit 12. Here, the virtual model may vary depending on the type of equipment operated by the equipment operation device, and may include one or more virtual models which are set for one or more equipments installed in various facilities such as plants and manufacturing facilities.

The control program in the virtual world can be modified according to information about the current operating state, and the control program is transmitted to the equipment control unit 22 in the equipment operation device in the real world when the control program is completed. The control program can be downloaded from the virtual model control unit 12 of the digital twin object to the equipment control unit 22 of the actual equipment operation device, or uploaded from the equipment control unit 22 to the virtual model control unit 12.

Operators or managers of manufacturing facilities can check operating status of manufacturing equipments in real time through the digital twin, which is a virtual representation of an actual plant, and can check manufacturing facility operation data, such as breakdowns or accidents, through the digital twin.

However, in FIG. 1, the virtual model operation unit 11 and the virtual model control unit 12 in the digital twin object may correspond to the equipment driving unit 21 and the equipment control unit 22 in the real world, respectively, but there exist no component corresponding to the automatic correction logic calculation unit (23). In other words, in the typical equipment test operation system shown in FIG. 1, the equipments can only be test run through the virtual model operation unit 11 in the virtual world according to user's commands using the virtual model control unit 12, and the automatic correction logic does not apply to the control program.

In this way, using digital twin technology, it is possible to check whether the equipment operates according to the control program in the virtual world and transfer the control program to the actual equipment. However, even when using digital twin technology, there was a problem in that it was impossible to check, before manufacturing new equipments, whether the control program could be corrected according to the automatic correction logic.

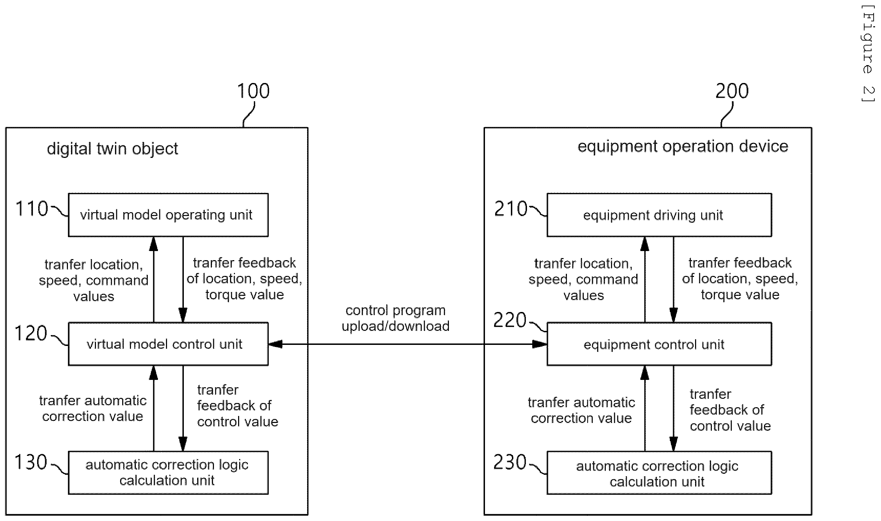

FIG. 2 is a block diagram of a system for test running of equipment using a digital twin according to embodiments of the present invention.

A digital twin is a replica model within the digital world and is used as a virtual model that reflects basic properties and real-world situations of an object and mimics its characteristics and behavior. In this specification, the object may be equipment operating devices, manufacturing machineries or devices, and a system including them used in one or more processes among a plurality of processes related to battery manufacturing.

Meanwhile, the equipment operation device 200 according to embodiments of the present invention may be a device for manufacturing related products by operating various devices, parts, and device sensors in the manufacturing facility, and may be configured to include an equipment driving unit 210, an equipment control unit 220, and an automatic correction logic calculation unit 230.

The equipment driving unit 210 may be connected to various devices within the manufacturing facility and operate devices, parts, and sensors which are interconnected with the equipment driving unit 210, according to commands from the equipment control unit 220. The equipment driving unit 210 may include, for example, a motor, a cylinder, etc. The automatic correction logic calculation unit 230 may calculate correction logic for the control program according to detected values related to the quality of the product manufactured according to the operation of the equipment and transmit the correction logic to the equipment control unit 220.

For example, the equipment control unit 220 may transmit command values related to position, speed, acceleration and deceleration of devices, parts, and sensors in the equipment to the equipment driving unit 210. The equipment driving unit 210 may transmit position, speed, acceleration/deceleration, torque, and sensor values of devices, parts, and sensors to the equipment control unit 220 as feedback. Here, the equipment control unit 220 may include a Programmable Logic Controller (PLC), Human Machine Interface (HMI), etc.

The equipment control unit 220 may transmit control value-related feedbacks (eg, control change value, control change time) among the information fed back from the equipment drive unit 210 to the automatic correction logic calculation unit 230.

The automatic correction logic calculation unit 230 may reflect trend data as well as feedback from the equipment control unit 220, calculate one or more control correction values according to the automatic correction logic, and transmit the one or more control correction values to the control program of the equipment control unit 220. Here, trend data may be data generated based on product quality-related measurements input through inspection equipment such as a vision inspection device, and may be an average of product quality-related measurements that are generated in a certain unit (e.g., lot unit). The inspection equipment may inspect a product in a production process according to an inspection command from the equipment control unit 220, determine whether the product is good or defective, and provide the results to the equipment control unit.

Here, devices, parts, and sensors which are placed in the facility may be devices, parts, and sensors in the state of semi-finished products or raw materials for test operation.

Additionally, the digital twin object 100 according to embodiments of the present invention may be configured to include a virtual model operation unit 110, a virtual model control unit 120, and an automatic correction logic calculation unit 130.

The virtual model control unit 120 may perform virtual input/ouput (I/O), drive, and safety control using PLC, motion, HMI, and safety control programs. The virtual model operation unit 110 may implement operation of the virtual model using equipment operation information, physical property information, constraints, sensors, and a sequence editor on a 3D drawing.

More specifically, the virtual model control unit 120 may transmit control command values related to position, speed, acceleration and deceleration for various devices and component equipment sensors in the virtual world to the virtual model operation unit 110. The virtual model operating unit 110 may operate various devices, components, and sensors in the virtual world according to the control command values. The virtual model operation unit 110 transmits information about current operating state of at least one equipment in the virtual world to the virtual model control unit 120. Here, information about the current operating state may include feedback on the control command values received from the virtual model control unit 120 and may include the location, speed, acceleration /deceleration, torque, and sensor values of the at least one equipment in the virtual world.

The virtual model control unit 120 may transmit control value-related feedbacks among the information fed back from the virtual model operation unit 110 to the automatic correction logic calculation unit 130. The control program of the virtual model control unit 120 in the digital twin object may be downloaded to the equipment control unit 220 in the equipment operation device in real world. On the other hand, the control program of the equipment control unit 220 may be uploaded to the virtual model control unit 120. Here, the control program may be a Programmable Logic Controller (PLC), motion, Human Man Interface (HMI), or safety control program.

In addition, the automatic correction logic calculation unit 130 may receive feedbacks and a separate external input from the virtual model operation unit 110, calculate at least one automatic correction value according to internal logic, and then transmit the necessary control values to the virtual model control unit and transmit the automatic correction software to the automatic correction logic calculation unit 230 in the real world. On the other hand, the automatic correction software of the automatic correction logic calculation unit 230 in real world may be uploaded to the automatic correction logic calculation unit 130 in the digital twin object.

Meanwhile, the equipment operation device 200 according to the present invention may be a device that controls and manages operations of equipments for manufacturing cylindrical, pouch, and prismatic batteries, especially cylindrical batteries of various specifications. The equipments for battery manufacturing may include, for example, various types of mixers, tanks, roll-to-roll equipments, slitters, cutters, and dryers used in electrode processing. The equipments for battery manufacturing may also include press notching equipments, laser notching equipments, winding equipments, stacking equipments, and packaging equipments used in the assembly process and may include charge and discharge (formation) equipments, aging equipment, classifiers, sorters, etc. used in the formation process.

In addition, the battery process to which equipment test operation using the digital twin according to the present invention can be applied may include various detailed processes such as a beading process, an electrolyte injecting process, a roll press process, an electrode process, and a notching process.

Through the virtual test run of the digital twin object of the present invention explained through embodiments, it is possible to develop and verify the control program when manufacturing and assembling equipments, thereby shortening equipment manufacturing time. In other words, conventionally, when manufacturing equipments, assembly of the machineries and configuration of the control program were done sequentially, whereas, when applying the digital twin object according to the present invention, the configuration of the control program can also be completed at the same time as the assembly of the machineries.

In addition, the automatic correction logic calculation unit could not be verified in advance in the case of existing digital twins, but in the present invention, the automatic compensation logic calculation unit can be also verified at the time of equipment production and assembly, so that the basic properties and actual situation of the object can be more realistically reflected.

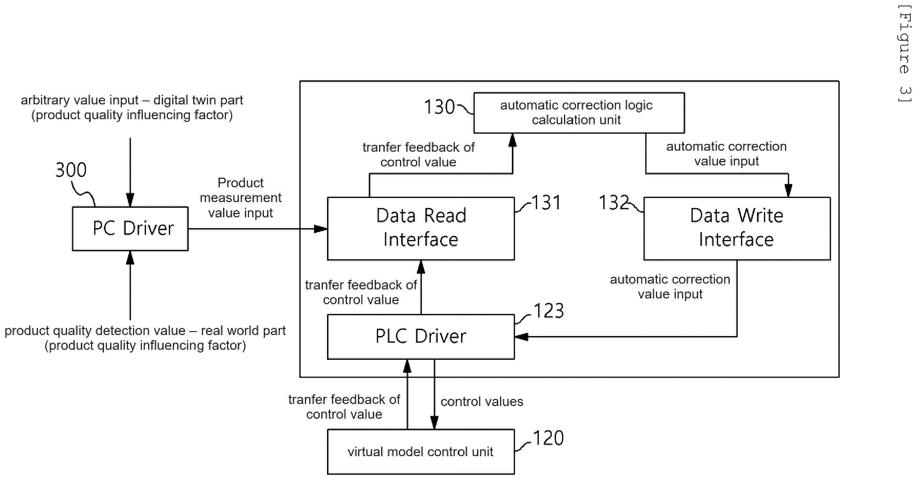

FIG. 3 is a diagram for explaining automatic correction logic in the system for test running of equipment using a digital twin according to embodiments of the present invention.

In general, when producing a product, differences in quality (dimensions, etc.) among products exist within a certain range for each production stage. Here, correcting one or more control values initially input by an operator based on equipment data can improve product quality and minimize defects. Somehow, when the operator manually corrects any control value, the quality data can be aperiodically checked and a process of determining whether to adjust control parameters, determining the amount of correction, and reflecting them in product production needs to be performed. Here, each operator may have different judgments regarding whether to adjust control parameters, and amount of correction, etc., and eventually, different results may occur for the same case.

In other words, when an operator controls equipment by arbitrarily adjusting dimensions according to product production results, quality deviations may exist depending on the operator's skill level and there is also the possibility of quality deterioration due to non-periodic adjustments of control values.

On the other hand, automatic correction controls the equipment by automatically adjusting the dimensions according to the product production results, so that quality deviation can be minimized using certain logic, and product quality can also be improved through periodic adjustment.

The automatic correction logic calculation unit 130 may receive at least one control value feedback and at least one arbitrary input value received from the virtual model control unit 120 and calculate at least one automatic correction value for at least one control value according to its internal logic. The automatic correction logic calculation unit 130 may transmit necessary control values to the virtual model control unit 120 and transmit automatic correction software to the automatic correction logic calculation unit 230 of the real world.

Here, the necessary conditions for that automatic correction is possible are that all semi-finished products or raw materials must be inspectable in real time, and parts that affect product quality must be controllable during the process. The automatic correction logic calculation unit 130 may automatically derive control factors according to the test results.

In embodiments of the present invention, control factors involved in the automatic correction logic may include, for example, control factors associated with one or more of the beading process, the electrolyte injection process, the roll press process, and the notching process.

Here, the control factors are control values for the operation of equipments in the virtual world. For example, the control factors in the beading process may include one or more of the upper servo movement distance, the lower servo movement distance, the rotation speed of a cell, and the knife servo movement distance. Additionally, the control values for the operation of equipment in the virtual world in the electrolyte injection process, may include the amount of electrolyte injection.

Referring to FIG. 3, the automatic correction logic calculation unit 130 may receive control value feedbacks from the virtual model control unit 120 through the data read interface 131 and receive inspection and measurement values of a product through a separate PC driver 300. Here, the inspection and measurement values of a product are product-related values measured as a result of facility inspection and operation and the inspection and measurement values may be product quality influencing factors that can affect product quality. The inspection measurement value of a product may include a value indicating whether the product is defective or, unit data generated in a certain unit (lot unit or tray unit) in case of a normal product. In the digital twin world, the inspection measurement value may be set to an arbitrary value.

The automatic correction logic calculation unit 130 may calculate a correction amount from data obtained through inspection and measurements and the automatic correction value calculated by the automatic correction logic calculation unit 130 may be output through a data write interface (Data Write Interface 132) and be transmitted to the virtual model control unit 120 through the PLC driver 123. Here, the correction amount/ correction value may be stored in a PLC data area along with the measured values.

In addition, the PLC driver 123 may convert an automatic correction value calculated by the automatic correction logic calculation unit 130 into a PLC control value and provide the PLC control value to the virtual model control unit 120, and may receive control value feedbacks of the virtual model control unit 120 and forward the control value feedbacks to the automatic correction logic calculation unit 130.

Here, Programmable Logic Controller (PLC) is an industrial controller that replaces functions such as relay, timer, counter, etc. which were previously used in industrial sites with a semiconductor device and is capable of controlling various types of machines or processes through digital or analog input/output units.

The operations of the automatic correction logic calculation unit 130 in the digital twin object described above may be applied equally to the operation of the automatic correction logic calculation unit 230 in the real world. However, the value input as the product quality influence factor (can be an arbitrary value) may be a product quality detection value in actual equipments.

Here, the product quality detection value in actual equipment may be a value derived by analyzing images of the product. A separate imaging device and/or computing device may be required for image detection and analysis of the product and the product quality detection value obtained through image detection and analysis may ge transmitted from the PC driver 300 to the automatic correction logic calculation unit 130 through the data read interface 131.

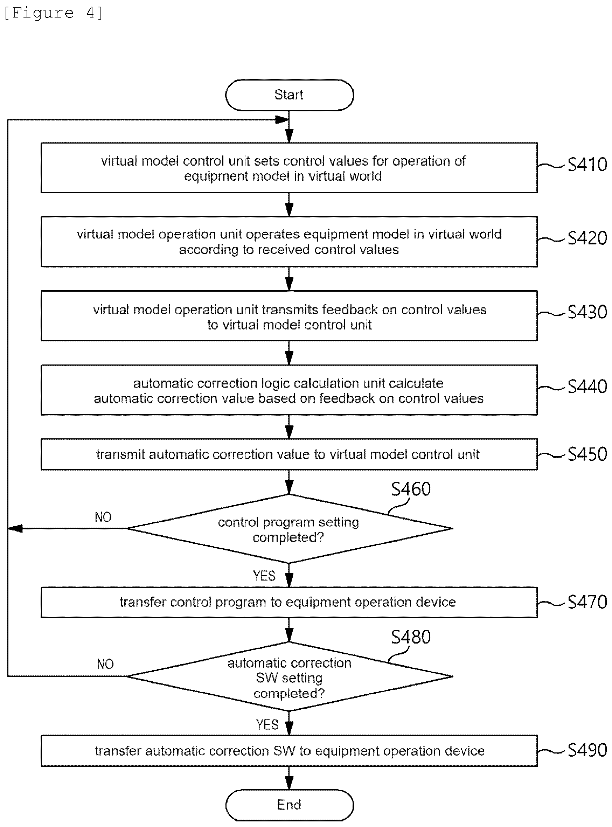

FIG. 4 is an operational flowchart of a method for test running of equipment according to embodiments of the present invention.

The method for test running of equipment according to embodiments of the present invention shown in FIG. 4 may be performed by a digital twin object. In the present invention, the digital twin object may include a virtual model operation unit, a virtual model control unit, and an automatic correction logic calculation unit.

The virtual model control unit in the digital twin object may set control values for operation of the equipment model within the virtual world and transmit the control values to the virtual model operation unit (S410). The virtual model operation unit may receive the control values and operate at least one equipment model in the virtual world according to the received control values (S420).

The virtual model operation unit may transmit feedback on control values obtained as a result of operating the equipment model to the virtual model control unit (S430). The feedback on the control values may be transmitted from the virtual model control unit to the automatic correction logic calculation unit and the automatic correction logic calculation unit may calculate at least one automatic correction value for a virtual model control program based on the feedback on the control values (S440). The calculated at least one automatic correction value may be transmitted to the virtual model control unit (S450).

When the control program is completely set (Yes in S460), the digital twin object may transfer the control program to the equipment operation device (S470). In addition, when the settings for the automatic correction software is completed (Yes in S480), the digital twin object may transfer the set automatic correction software to the equipment operation device (S490).

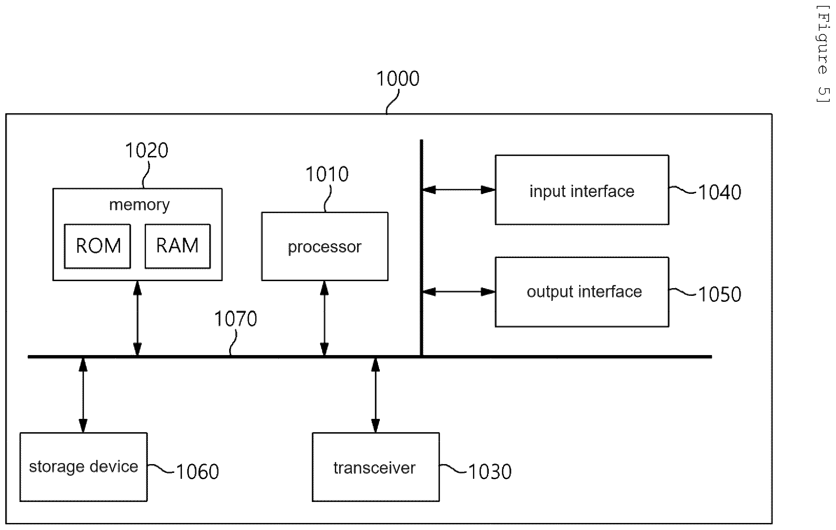

FIG. 5 is a block diagram of a control apparatus for equipment test running according to embodiments of the present invention.

The control apparatus for equipment test running 1000 according to embodiments of the present invention may include at least one processor 1010, a memory 1020 that stores at least one instruction executed by the at least one processor, and a transceiver 1030 that is connected to a network and performs communication.

The at least one instruction may include an instruction to create a digital twin object including a virtual model operation unit, a virtual model control unit, and an automatic correction logic calculation unit; an instruction for the virtual model operation unit to operate at least one equipment model in the virtual world according to at least one control value; an instruction for the virtual model control unit to set at least one control value for operation of at least one equipment in the virtual world and transmit the at least one control value to the virtual model operation unit; an instruction for the virtual model control unit to receive at least one feedback on the at least one control value from the virtual model operation unit; an instruction for the automatic correction logic calculation unit to calculate at least one correction value for a virtual model control program based on the at least one feedback on the at least one control value; and an instruction for the automatic correction logic calculation unit to transmit the at least one correction value for the virtual model control program to the virtual model control unit.

The at least one instruction may further include an instruction to transmit the control program which is determined by the virtual model control unit to an equipment control unit within the equipment operation device.

The at least one instruction may further include an instruction to transmit the automatic correction software determined by the automatic correction logic calculation unit to an automatic correction logic calculation unit in the equipment operation device.

The at least one control value for the operation of at least one equipment in the virtual world may include one or more command values related to a position and a speed of each equipment.

The instruction for the automatic correction logic calculation unit to calculate at least one correction value for a virtual model control program may include an instruction to calculate the automatic correction logic by additionally considering product quality influencing factors along with the at least one feedback on the at least one control value.

The control apparatus for equipment test running 1000 may further include an input interface device 1040, an output interface device 1050, a storage device 1060, etc. Respective components included in the control apparatus for equipment test running 1000 may be connected by a bus 1070 and can communicate with each other.

Here, the processor 1010 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

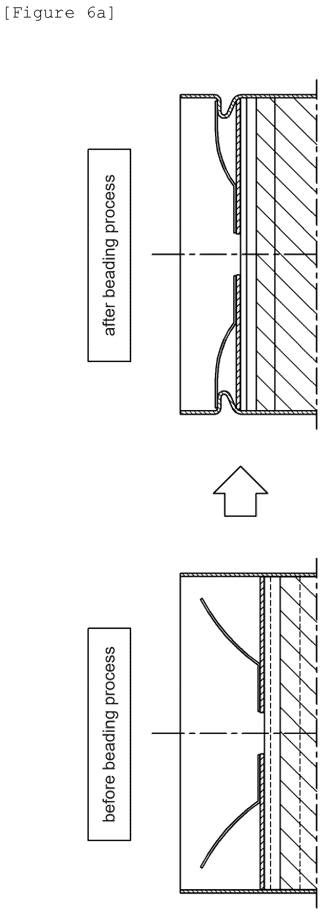

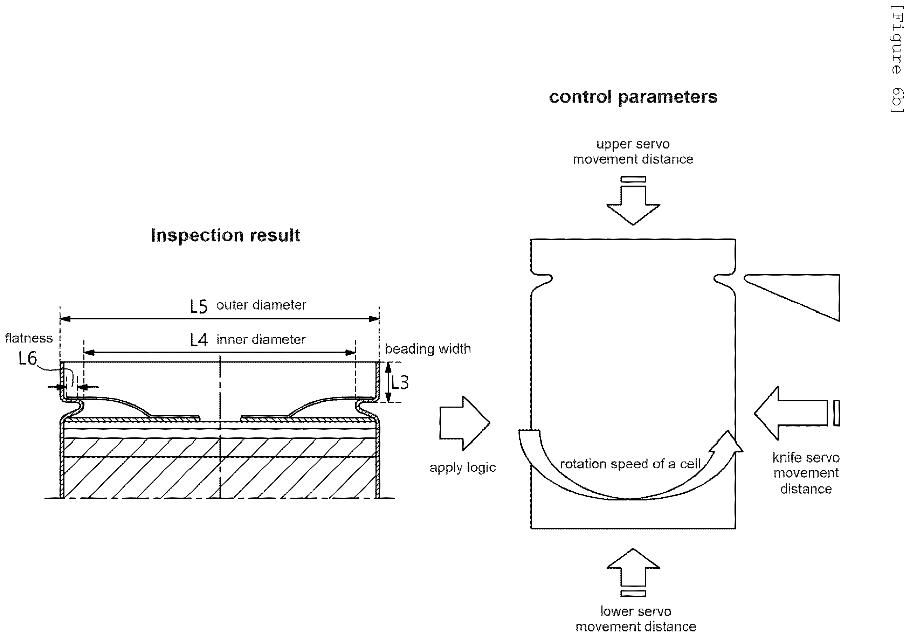

FIG. 6a is a diagram illustrating a beading process during battery manufacturing process, and FIG. 6b illustrates an example of automatic correction control factors when applying the automatic correction logic to the beading process according to embodiments of the present invention.

Referring to FIG. 6a, the beading process is a process of putting a jelly roll into a battery can and molding the straight can into a neck shape to secure the jelly roll inside the can.

After the beading process, the shape of the can is partially inconsistent and needs to be adjusted. According to the prior art, quality adjustment used to be performed by checking inspection data after the beading process, determining whether control parameters are necessary, and manually arbitrarily correcting the control parameters related to the beading process based on operator's experience.

Using the automatic correction method according to the present invention, it is possible to maintain constant dimensional quality even for products which are judged to have good quality, thereby reducing deviation in product shape. In addition, the part where the operator manually adjusts parameters can be automated.

For this, in the present invention, as shown in FIG. 6b, the dimensions of the outer diameter (L5), inner diameter (L4), flatness (L6), and beading width (L3) of the battery can after the beading process may be inspected. Afterwards, if it is determined that correction is necessary by comparing the inspected dimensions with the standard dimensions, automatic correction logic may be applied to automatically correct the control factors that affect the dimensions. Here, the control factors affecting the beading process may include an upper servo movement distance, a lower servo movement distance, a rotation speed of a cell, and a knife servo movement distance.

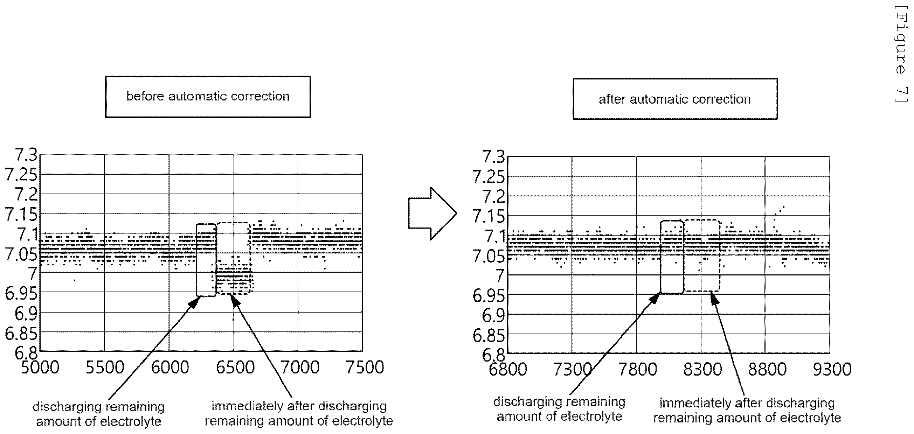

FIG. 7 shows an example of an automatic correction control factor when applying the automatic correction logic to a electrolyte injection process according to embodiments of the present invention.

The electrolyte injection process is a process of injecting electrolyte in which creates a vacuum inside the battery can after the beading process is completed, injects a fixed amount of electrolyte through a nozzle into a pallet on which the battery cells are placed, and then applies pressure to allow the electrolyte to seep into the pores of the electrode.

In this process, a large number of defects in electrolyte bottom line limit may occur immediately after discharging remaining amount of electrolyte. In particular, if the electrolyte is discharged when no cells are included in the pallet, the remaining amount of electrolyte disappears due to vacuum pressure, and there is a high possibility that a defect of electrolyte bottom line limit will occur in the next pallet.

To solve this problem, in the present invention, the injection amount inspection data may be analyzed and the deviation can be reduced by injecting additional electrolyte amount by the amount decreased after the remaining electrolyte amount is discharged.

FIG. 7 is a graph showing the weight of the battery cell changing with time during the electrolyte injection process. The graph on the left shows the change in weight of the battery cell when automatic compensation is not applied whereas the graph on the right shows the change in weight of the battery cell when automatic compensation according to the present invention is applied. As can be seen in the right graph of FIG. 7, according to embodiments of the present invention, the weight deviation of the battery cell before and immediately after discharging the remaining amount of electrolyte can be reduced. The control factor in this embodiment applied to the electrolyte injection process may be the electrolyte injection amount.

In addition, embodiments according to the present invention can provide automatic correction logic to solve problems in a roll press process during the battery manufacturing process.

Specifically, during the roll press process, the roll may bend due to heat generation from the roller. According to the prior art, the operator used to apply counter pressure through manual adjustment to eliminate the roll bending.

However, the embodiments of the present invention may collect periodic data related to the thickness of the electrode plate through a Programmable Logic Controller (PLC) linked to a thickness gauge that measures the thickness of the electrode plate, compare the thickness of the center of electrode plate and the thickness of the end of the electrode plate, calculate the thickness difference between the center and the end of the electrode plate, and determine whether correction is necessary, thereby performing automatic correction for at least one control factor that requires correction.

Additionally, the embodiments according to the present invention may provide automatic correction logic to solve problems in a notching (NTC) process during the battery manufacturing process. In the notching process, a deviation in heights of the shoulder lines between the positive terminals of the plurality of battery cells being manufactured may be identified. In this embodiment, vision data of the battery cell, including pitch (spacing between electrodes) values and shoulder line height values acquired through a vision device, an edge position control (EPC) sensor, etc., may be analyzed. Afterwards, if it is determined that control for adjusting the value is necessary, pitch position adjustment and shoulder line height adjustment may be performed using the PLC, etc.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the scope of the appended claims, which define the invention.

## Claims

1. A system for test running of equipment used in one or more of a plurality of processes involved in rechargeable battery manufacturing, wherein the system includes a digital twin object (10, 100),
wherein the digital twin object (10, 100) includes:
a virtual model operating unit configured to operate at least one equipment in a virtual world according to at least one control value;
a virtual model control unit (12, 120) configured to set at least one control value for operation of at least one equipment in the virtual world and transmit the at least one control value to the virtual model operation unit (11, 110) and receive at least one feedback on the at least one control value from the virtual model operation unit (11, 110), wherein the at least one control value for the operation of the at least one equipment in the virtual world includes one or more control values associated with one or more of a beading process, an electrolyte injection process, a roll press process, and a notching process; and
an automatic correction logic calculation unit configured to calculate at least one correction value for a virtual model control program based on the at least one feedback on the at least one control value and transmit the at least one correction value to the virtual model control unit (12, 120),
wherein the virtual model control unit (12, 120) is configured to receive the control program from an equipment control unit (22, 220) within an equipment operation device (20, 200) and to transmit the control program to the equipment operation device (20, 200) when settings to the control program have been completed.

2. The system of claim 1, further comprising an equipment operation device (20, 200) which includes an equipment driving unit corresponding to the virtual model operating unit, an equipment control unit (22, 220) corresponding to the virtual model control unit (12, 120), and an automatic correction logic calculation unit corresponding to the automatic correction logic calculation unit of the digital twin object (10, 100).

3. The system of claim 1, wherein the automatic correction logic calculation unit is configured to determine an automatic correction software and to transmit the automatic correction software to the automatic correction logic calculation unit in the equipment operation device (20, 200).

4. The system of claim 1, wherein the at least one control value for the operation of at least one equipment in the virtual world includes one or more command value related to a position and a speed of each equipment.

5. The system of claim 1, wherein the at least one control value for the operation of the at least one equipment in the virtual world includes one or more control values of an upper servo movement distance, a lower servo movement distance, a cell rotation speed, and a knife servo movement distance in the beading process.

6. The system of claim 1, wherein the at least one control value for the operation of the at least one equipment in the virtual world includes an amount of electrolyte injection in the electrolyte injection process.

7. The system of claim 1, wherein the automatic correction logic calculation unit is configured to calculate the automatic correction logic by additionally considering product quality influencing factors along with the at least one feedback on the at least one control value.

8. The system of claim 3, wherein the automatic correction logic calculation unit in the equipment operation device (20, 200) is configured to calculate automatic correction logic for the control program based on automatic correction software downloaded from the digital twin object (10, 100) and in consideration of at least one detected product quality related value.

9. A method for test running of equipment used in one or more of a plurality of processes involved in rechargeable battery manufacturing, said method using a digital twin object (10, 100) including a virtual model operation unit (11, 110), a virtual model control unit (12, 120), and an automatic correction logic calculation unit, the method comprising:
determining, by the virtual model control unit (12, 120), at least one control value for operation of at least one equipment in a virtual world and transmitting the at least one control value to the virtual model operation unit (11, 110), wherein the at least one control value for the operation of the at least one equipment in the virtual world includes one or more control values associated with one or more of a beading process, a electrolyte injection process, a roll press process, and a notching process;
operating, by the virtual model operation unit (11, 110), at least one equipment model in the virtual world according to the at least one control value received from the virtual model control unit (12, 120);
transmitting, by the virtual model operation unit (11, 110), at least one feedback on the at least one control value to the virtual model control unit (12, 120);
calculating, by the automatic correction logic calculation unit, at least one correction value for a virtual model control program based on the at least one feedback on the at least one control value; and
transmitting, by the automatic correction logic calculation unit, the at least one correction value for the virtual model control program to the virtual model control unit (12, 120),
wherein the control program is received from an equipment control unit (22, 220) within an equipment operation device (20, 200) and is transmitted to the equipment operation device (20, 200) when settings to the control program have been completed.

## Patentansprüche

1. System zum Testlauf von Ausrüstung, die in einem oder mehreren einer Vielzahl von Prozessen verwendet wird, die an der Herstellung einer wiederaufladbaren Batterie beteiligt sind, wobei das System ein digitales Zwillingsobjekt (10, 100) beinhaltet,
wobei das digitale Zwillingsobjekt (10, 100) Folgendes beinhaltet:
eine virtuelle Modellbetriebseinheit, die konfiguriert ist, um mindestens eine Ausrüstung in einer virtuellen Welt gemäß mindestens einem Steuerwert zu betreiben;
eine virtuelle Modellsteuereinheit (12, 120), die konfiguriert ist, um mindestens einen Steuerwert für den Betrieb mindestens einer Ausrüstung in der virtuellen Welt einzustellen und den mindestens einen Steuerwert an die virtuelle Modellbetriebseinheit (11, 110) zu übertragen und mindestens eine Rückmeldung auf den mindestens einen Steuerwert von der virtuellen Modellbetriebseinheit (11, 110) zu empfangen, wobei der mindestens eine Steuerwert für den Betrieb der mindestens einen Ausrüstung in der virtuellen Welt einen oder mehrere Steuerwerte beinhaltet, die einem oder mehreren von einem Wulstbildungsprozess, einem Elektrolytinjektionsprozess, einem Walzenpressprozess und einem Kerbprozess zugeordnet sind; und
eine automatische Korrekturlogikberechnungseinheit, die konfiguriert ist, um mindestens einen Korrekturwert für ein virtuelles Modellsteuerprogramm basierend auf der mindestens einen Rückmeldung auf den mindestens einen Steuerwert zu berechnen und den mindestens einen Korrekturwert an die virtuelle Modellsteuereinheit (12, 120) zu übertragen,
wobei die virtuelle Modellsteuereinheit (12, 120) konfiguriert ist, um das Steuerprogramm von einer Ausrüstungssteuereinheit (22, 220) innerhalb einer Ausrüstungsbetriebsvorrichtung (20, 200) zu empfangen und das Steuerprogramm an die Ausrüstungsbetriebsvorrichtung (20, 200) zu übertragen, wenn Einstellungen für das Steuerprogramm abgeschlossen wurden.

2. System nach Anspruch 1, ferner umfassend eine Ausrüstungsbetriebsvorrichtung (20, 200), die eine Ausrüstungsantriebseinheit beinhaltet, die der virtuellen Modellbetriebseinheit entspricht, eine Ausrüstungssteuereinheit (22, 220), die der virtuellen Modellsteuereinheit (12, 120) entspricht, und eine automatische Korrekturlogikberechnungseinheit, die der automatischen Korrekturlogikberechnungseinheit des digitalen Zwillingsobjekts (10, 100) entspricht.

3. System nach Anspruch 1, wobei die automatische Korrekturlogikberechnungseinheit konfiguriert ist, um eine automatische Korrektursoftware zu bestimmen und die automatische Korrektursoftware an die automatische Korrekturlogikberechnungseinheit in der Ausrüstungsbetriebsvorrichtung (20, 200) zu übertragen.

4. System nach Anspruch 1, wobei der mindestens eine Steuerwert für den Betrieb mindestens einer Ausrüstung in der virtuellen Welt einen oder mehrere Befehlswerte beinhaltet, die sich auf eine Position und eine Geschwindigkeit jeder Ausrüstung beziehen.

5. System nach Anspruch 1, wobei der mindestens eine Steuerwert für den Betrieb der mindestens einen Ausrüstung in der virtuellen Welt einen oder mehrere Steuerwerte eines oberen Servobewegungsabstands, eines unteren Servobewegungsabstands, einer Zellenrotationsgeschwindigkeit und eines Messerservobewegungsabstands in dem Wulstbildungsprozess beinhaltet.

6. System nach Anspruch 1, wobei der mindestens eine Steuerwert für den Betrieb der mindestens einen Ausrüstung in der virtuellen Welt eine Menge an Elektrolytinjektion in dem Elektrolytinjektionsprozess beinhaltet.

7. System nach Anspruch 1, wobei die automatische Korrekturlogikberechnungseinheit konfiguriert ist, um die automatische Korrekturlogik durch zusätzliches Berücksichtigen von Produktqualitätseinflussfaktoren zusammen mit der mindestens einen Rückmeldung auf den mindestens einen Steuerwert zu berechnen.

8. System nach Anspruch 3, wobei die automatische Korrekturlogikberechnungseinheit in der Ausrüstungsbetriebsvorrichtung (20, 200) konfiguriert ist, um eine automatische Korrekturlogik für das Steuerprogramm basierend auf automatischer Korrektursoftware, die von dem digitalen Zwillingsobjekt (10, 100) heruntergeladen wird, und unter Berücksichtigung mindestens eines erfassten produktqualitätsbezogenen Werts zu berechnen.

9. Verfahren zum Testlauf von Ausrüstung, die in einem oder mehreren einer Vielzahl von Prozessen verwendet wird, die an der Herstellung einer wiederaufladbaren Batterie beteiligt sind, wobei das Verfahren ein digitales Zwillingsobjekt (10, 100) verwendet, das eine virtuelle Modellbetriebseinheit (11, 110), eine virtuelle Modellsteuereinheit (12, 120) und eine automatische Korrekturlogikberechnungseinheit beinhaltet, wobei das Verfahren Folgendes umfasst:
Bestimmen, durch die virtuelle Modellsteuereinheit (12, 120), mindestens eines Steuerwerts für den Betrieb mindestens einer Ausrüstung in einer virtuellen Welt und Übertragen des mindestens einen Steuerwerts an die virtuelle Modellbetriebseinheit (11, 110), wobei der mindestens eine Steuerwert für den Betrieb der mindestens einen Ausrüstung in der virtuellen Welt einen oder mehrere Steuerwerte beinhaltet, die einem oder mehreren von einem Wulstbildungsprozess, einem Elektrolytinjektionsprozess, einem Walzenpressprozess und einem Kerbprozess zugeordnet sind;
Betreiben, durch die virtuelle Modellbetriebseinheit (11, 110), mindestens eines Ausrüstungsmodells in der virtuellen Welt gemäß dem mindestens einen Steuerwert, der von der virtuellen Modellsteuereinheit (12, 120) empfangen wird;
Übertragen, durch die virtuelle Modellbetriebseinheit (11, 110), mindestens einer Rückmeldung auf den mindestens einen Steuerwert an die virtuelle Modellsteuereinheit (12, 120);
Berechnen, durch die automatische Korrekturlogikberechnungseinheit, mindestens eines Korrekturwertes für ein virtuelles Modellsteuerprogramm basierend auf der mindestens einen Rückmeldung auf den mindestens einen Steuerwert; und
Übertragen, durch die automatische Korrekturlogikberechnungseinheit, des mindestens einen Korrekturwertes für das virtuelle Modellsteuerprogramm an die virtuelle Modellsteuereinheit (12, 120),
wobei das Steuerprogramm von einer Ausrüstungssteuereinheit (22, 220) innerhalb einer Ausrüstungsbetriebsvorrichtung (20, 200) empfangen wird und an die Ausrüstungsbetriebsvorrichtung (20, 200) übertragen wird, wenn Einstellungen für das Steuerprogramm abgeschlossen wurden.

## Revendications

1. Système d'essai de fonctionnement d'équipement utilisé dans un ou plusieurs processus parmi une pluralité de processus liés à la fabrication de batteries rechargeables, dans lequel le système comprend un objet jumeau numérique (10, 100),
dans lequel l'objet jumeau numérique (10, 100) comprend :
une unité de commande de modèle virtuel configurée pour faire fonctionner au moins un équipement dans un monde virtuel selon au moins une valeur de contrôle ;
une unité de contrôle de modèle virtuel (12, 120) configurée pour définir au moins une valeur de contrôle servant à des fins de fonctionnement d'au moins un équipement dans le monde virtuel et pour transmettre ladite au moins une valeur de contrôle à l'unité de commande de modèle virtuel (11, 110) et pour recevoir au moins une rétroaction se rapportant à ladite au moins une valeur de contrôle en provenance de l'unité de commande de modèle virtuel (11, 110), dans lequel ladite au moins une valeur de contrôle servant à des fins de fonctionnement dudit au moins un équipement dans le monde virtuel comprend une ou plusieurs valeurs de contrôle associées à un ou plusieurs processus parmi un processus de nervurage, un processus d'injection d'électrolyte, un processus de pression au rouleau et un processus d'encochage ; et
une unité de calcul de logique de correction automatique configurée pour calculer au moins une valeur de correction pour un programme de contrôle de modèle virtuel sur la base de ladite au moins une rétroaction se rapportant à ladite au moins une valeur de contrôle et pour transmettre ladite au moins une valeur de correction à l'unité de contrôle de modèle virtuel (12, 120),
dans lequel l'unité de contrôle de modèle virtuel (12, 120) est configurée pour recevoir le programme de contrôle en provenance d'une unité de contrôle d'équipement (22, 220) dans un dispositif de commande d'équipement (20, 200) et pour transmettre le programme de contrôle au dispositif de commande d'équipement (20, 200) quand les réglages du programme de contrôle ont été effectués.

2. Système selon la revendication 1, comportant par ailleurs un dispositif de commande d'équipement (20, 200) qui comprend une unité d'entraînement d'équipement correspondant à l'unité de commande de modèle virtuel, une unité de contrôle d'équipement (22, 220) correspondant à l'unité de contrôle de modèle virtuel (12, 120) et une unité de calcul de logique de correction automatique correspondant à l'unité de calcul de logique de correction automatique de l'objet jumeau numérique (10, 100).

3. Système selon la revendication 1, dans lequel l'unité de calcul de logique de correction automatique est configurée pour déterminer un logiciel de correction automatique et pour transmettre le logiciel de correction automatique à l'unité de calcul de logique de correction automatique dans le dispositif de commande d'équipement (20, 200).

4. Système selon la revendication 1, dans lequel ladite au moins une valeur de contrôle servant à des fins de fonctionnement d'au moins un équipement dans le monde virtuel comprend une ou plusieurs valeurs de contrôle liées à une position et à une vitesse de chaque équipement.

5. Système selon la revendication 1, dans lequel ladite au moins une valeur de contrôle servant à des fins de fonctionnement dudit au moins un équipement dans le monde virtuel comprend une ou plusieurs valeurs de contrôle d'une distance de mouvement d'asservissement supérieure, d'une distance de mouvement d'asservissement inférieure, d'une vitesse de rotation de pile, et d'une distance de mouvement d'asservissement de couteau au cours du processus de nervurage.

6. Système selon la revendication 1, dans lequel ladite au moins une valeur de contrôle servant à des fins de fonctionnement dudit au moins un équipement dans le monde virtuel comprend une quantité d'injection d'électrolyte au cours du processus d'injection d'électrolyte.

7. Système selon la revendication 1, dans lequel l'unité de calcul de logique de correction automatique est configurée pour calculer la logique de correction automatique en prenant de plus en considération des facteurs influençant la qualité du produit en même temps que ladite au moins une rétroaction se rapportant à ladite au moins une valeur de contrôle.

8. Système selon la revendication 3, dans lequel l'unité de calcul de logique de correction automatique dans le dispositif de commande d'équipement (20, 200) est configurée pour calculer la logique de correction automatique pour le programme de contrôle sur la base d'un logiciel de correction automatique téléchargé en provenance de l'objet jumeau numérique (10, 100) et en tenant compte d'au moins une valeur liée à la qualité du produit ayant été détectée.

9. Procédé d'essai de fonctionnement d'équipement utilisé dans un ou plusieurs processus parmi une pluralité de processus liés à la fabrication de batteries rechargeables, ledit procédé utilisant un objet jumeau numérique (10, 100) comprenant une unité de commande de modèle virtuel (11, 110), une unité de contrôle de modèle virtuel (12, 120) et une unité de calcul de logique de correction automatique, le procédé comportant les étapes consistant à :
déterminer, par l'unité de contrôle de modèle virtuel (12, 120), au moins une valeur de contrôle servant à des fins de fonctionnement d'au moins un équipement dans un monde virtuel et transmettre ladite au moins une valeur de contrôle à l'unité de commande de modèle virtuel (11, 110), dans lequel ladite au moins une valeur de contrôle servant à des fins de fonctionnement dudit au moins un équipement dans le monde virtuel comprend une ou plusieurs valeurs de contrôle associées à un ou plusieurs parmi un processus de nervurage, un processus d'injection d'électrolyte, un processus de pression au rouleau et un processus d'encochage ;
faire fonctionner, par l'unité de commande de modèle virtuel (11, 110), au moins un modèle d'équipement dans le monde virtuel en fonction de ladite au moins une valeur de contrôle reçue en provenance de l'unité de contrôle de modèle virtuel (12, 120) ;
transmettre, par l'unité de commande de modèle virtuel (11, 110), au moins une rétroaction se rapportant à ladite au moins une valeur de contrôle à l'unité de contrôle de modèle virtuel (12, 120) ;
calculer, par l'unité de calcul de logique de correction automatique, au moins une valeur de correction pour un programme de contrôle de modèle virtuel sur la base de ladite au moins une rétroaction se rapportant à ladite au moins une valeur de contrôle ; et
transmettre, par l'unité de calcul de logique de correction automatique, ladite au moins une valeur de correction pour le programme de contrôle de modèle virtuel à l'unité de contrôle de modèle virtuel (12, 120),
dans lequel le programme de contrôle est reçu en provenance d'une unité de contrôle d'équipement (22, 220) dans un dispositif de commande d'équipement (20, 200) et est transmis au dispositif de commande d'équipement (20, 200) quand les réglages du programme de contrôle ont été effectués.
